Europäisches Patentamt

(19) European Patent Office

Office européen des brevets

(11) Numéro de publication: **0 007 408**
**A1**

(12) **DEMANDE DE BREVET EUROPEEN**

(21) Numéro de dépôt: **79101841.9**

(22) Date de dépôt: **11.06.79**

(51) Int. Cl.³: **G 01 R 27/02**
**G 01 R 17/10, G 01 N 27/02**

(30) Priorité: **14.07.78 US 924776**

(43) Date de publication de la demande:
**06.02.80 Bulletin 80/3**

(84) Etats Contractants Désignés:
**DE FR GB**

(71) Demandeur: **International Business Machines Corporation**

**Armonk, N.Y. 10504(US)**

(72) Inventeur: **Elliott, Brian John**
**2021 Van Cortlandt Circle**
**Yorktown Heights, N.Y. 10598(US)**

(72) Inventeur: **Howard, Jr., Webster Eugene**
**1306 McKeel Street**
**Yorktown Heights, N.Y. 10698(US)**

(74) Mandataire: **Gallois, Gerard**
**COMPAGNIE IBM FRANCE Département de Propriété Industrielle**
**F-06610 - La Gaude(FR)**

(54) **Appareil de mesure sans contact de la résistance de feuille des matériaux.**

(57) L'appareil comprend un réseau en pont à courant alternatif (2) comportant un circuit accordé (8) constitué d'un élément inductif (10) pourvu d'un entrefer (12) dans lequel est inséré le matériau soumis à la mesure. L'introduction du matériau déséquilibre le pont résistivement et réactivement produisant un signal de déséquilibre au noeud (16) en réponse aux courants de Foucault produits dans le matériau. L'oscillateur (48) commandé en tension produit un signal alternatif excitant le pont par l'intermédiaire du transformateur (34). Un amplificateur à verrouillage (38) sensible à la phase répond au changement de phase du signal de déséquilibre par rapport à celle du signal de l'oscillateur pour modifier la fréquence de l'oscillateur pour contrebalancer la variation de la partie réactive du pont; l'amplitude du signal de déséquilibre, inversement proportionnelle à la résistance de feuille du matériau, est mesurée par l'amplificateur à verrouillage (42) sensible à l'amplitude et enregistrée par l'enregistreur (60). L'appareil peut être utilisé pour mesurer sans dommage une gamme étendue de résistances de fueille de matériaux en particulier dans la fabrication des circuits intégrés semiconducteurs.

Figure 1

./...

EP 0 007 408 A1

FIG. 1

1

# APPAREIL DE MESURE SANS CONTACT DE LA RESISTANCE DE FEUILLE DES MATERIAUX

## Description

### Domaine Technique

La présente invention concerne un procédé et un appareil de mesure sans contact de la résistance de feuille de matériaux, et plus particulièrement de semi-conducteurs, de films et de feuilles métalliques de films d'oxyde, de semi-métaux (tels que l'arsenic), de conducteurs ioniques bidimensionnels, d'arséniure de gallium polycristallin et de supports conducteurs et isotropes.

### Etat de la Technique Antérieure

La mesure de la conductivité ou de la résistivité électrique des solides minces joue un rôle très important dans le traitement de dispositifs à l'état solide. Par exemple, il est généralement nécessaire d'établir un classement des substrats semi-conducteurs avant que ces derniers ne fassent l'objet d'un traitement donné, afin de s'assurer que leur conductivité est inférieure à une valeur spécifiée ou comprise dans une gamme étroite de valeurs données. Pendant le traitement, il faut généralement contrôler les étapes de diffusion pour déterminer à quel moment la conductivité des tranches diffusées a augmenté ou diminué jusqu'à une valeur comprise dans une gamme étroite, laquelle correspond à la concentration désirée du dopant et aux profondeurs de diffusion requises.

2

Un grand nombre de diffusions sont effectuées au travers des ouvertures que comportent des couches de masquage. En pareil cas, une tranche de test peut être employée dans un but de contrôle. Le traitement des dispositifs à l'état solide comprend généralement le dépôt de couches métalliques permettant l'établissement d'un contact électrique entre les dispositifs que comporte un circuit intégré ou entre ce circuit et des circuits externes. L'épaisseur de la couche doit alors dépasser une valeur minimum donnée, afin qu'une conductivité suffisante puisse être obtenue, sans toutefois être telle qu'il en résulte un gaspillage de métaux précieux tels que l'or et le platine. Le contrôle de l'épaisseur des couches métalliques constitue donc une étape importante du processus de fabrication. L'un des procédés employés pour réaliser les mesures de conductivité nécessaire est la méthode dite des quatre points. Cependant, dans le cas de matériaux semi-conducteurs présentant une faible conductivité et des intervalles de bande importants, les procédés de ce type sont extrêmement difficiles à employer parce que les contacts entre la tranche qui fait l'objet des mesures et les éléments de la sonde à quatre points qui entre en contact avec elle tendent à être redresseurs. Par ailleurs, certaines diffusions sont effectuées au travers de couches vitreuses, ce qui rend difficile l'établissement d'un contact avec le semi-conducteur sous-jacent. Etant donné qu'elle entre directement en contact avec le matériau, la sonde à quatre points provoque des dommages et une contamination localisés. La région endommagée peut ainsi être rendue inutilisable, notamment dans le cas de dispositifs comportant des éléments de faibles dimensions. Les considérations ci-dessus mettent en évidence l'intérêt que présente la

3

mise au point d'un procédé de mesure sans contact.

Les divers procédés de mesure sans contact de la conductivité électrique qui ont été proposés pour pallier les limitations de la méthode des quatre points mettent généralement en oeuvre l'inter-action entre l'échantillon faisant l'objet de la mesure et des excitations à haute fréquence. Ces procédés peuvent produire des signaux de sortie non linéaires qui nécessitent un étalonnage dans la gamme d'utilisation, lequel est effectué en comparant les signaux mesurés avec une courbe d'étalonnage. Par ailleurs, ces mesures font généralement appel à l'emploi d'un volume de mesure relativement mal défini, par exemple approximativement hémisphérique, ce qui peut être tout à fait satisfaisant dans le cas de mesures d'échantillons uniformément conducteurs, mais augmente la complexité de l'analyse des résultats des mesures dans le cas d'échantillons non uniformes tels que des couches diffusées dans des matériaux semi-conducteurs.

Des techniques de mesure sans contact de la conductivité électrique d'échantillons plats et minces tels que des tranches semi-conductrices ou des films minces métalliques, ont récemment été proposées. Ces techniques permettent d'obtenir un signal de sortie très linéaire et de mesurer les porteurs conducteurs de façon uniforme en fonction de l'épaisseur du matériau; elles mesurent les effets des pertes dues aux courants de Foucault qui se produisent dans le matériau faisant l'objet du test, sur un circuit résonnant excité. Le brevet des E.U.A. No. 4 000 458 décrit un procédé de mesure de la résistance de feuille d'un matériau en mesurant à des fréquences ultrasoniques les effets

4

des pertes, dues aux courants de Foucault de haute fréquence, sur un circuit résonnant parallèle excité. Ce dernier présente un chemin de réaction qui comprend un pont résistif. Le courant continu moyen du circuit résonnant constitue une approximation linéaire de la conductivité du matériau en test.

Le brevet britannique No. 1 007 822 décrit un procédé de mesure de la résistivité électrique d'un matériau au moyen d'un circuit comprenant deux branches dont chacune possède une entrée couplée à une sortie au moyen d'un transformateur. La première branche comporte un atténuateur qui affaiblit le signal de sortie dans un rapport de 2 à 1. Le matériau à mesurer étant disposé entre les enroulements du transformateur que comporte la seconde branche, on modifie la fréquence du courant alternatif du signal d'entrée jusqu'à ce que le niveau de sortie de la seconde branche soit égal à celui de la première, la fréquence du dispositif d'entrée constituant alors une indication linéaire de la résistivité de l'échantillon.

Le brevet des E.U.A. No. 3 805 160 décrit un procédé permettant de mesurer la résistivité de matériaux semi-conducteurs sur plusieurs décades en faisant varier l'inductance d'une bobine excitée par des signaux haute fréquence, ce procédé étant indépendant de la fréquence de fonctionnement, du type de matériau semi-conducteur, de la nature de la surface de l'échantillon et de l'état ou de la préparation de cette surface.

Le brevet des E.U.A. No. 3 544 893 décrit un procédé de mesure sans contact de la résistivité d'un semi-conducteur qui consiste à faire passer des microplaquettes

5

semi-conductrices dans l'entrefer de la bobine toroïdale d'un circuit résonnant parallèle et à mesurer la
variation absolue du facteur Q du circuit, cette mesure
donnant la résistivité des microplaquettes semi-conductrices. Ce circuit comprend un pont de mesure fonctionnant en courant continu et la bobine toroïdale constitue
un auto-oscillateur HF connecté à l'une des branches du
pont, une charge étant incorporée à la diagonale de ce
dernier, qui fournit un signal indiquant la valeur de
la résistivité des microplaquettes semi-conductrices.

## Exposé de l'Invention

Le procédé de mesure sans contact de la résistance de
feuille d'un matériau, conformément à la présente
invention, consiste à mesurer les effets sur un circuit accordé excité des pertes dues aux courants de
Foucault qui se produisent à des fréquences ultrasoniques dans le matériau faisant l'objet des mesures.
Ce circuit accordé excité constitue l'une des branches
d'un pont résistif fonctionnant en courant alternatif.
Un système précis de réglage automatique de la fréquence, comprenant un amplificateur à verrouillage sensible à la phase et un oscillateur commandé en tension,
maintient le pont dans un mode essentiellement résistif
lorsque la valeur de l'inductance du circuit accordé
est modifiée par l'échantillon de matériau, lequel présente une résistance de feuille $R_s$. Les perturbations
de l'entrefer du circuit accordé qui sont créées par un
matériau présentant des pertes produisent un signal caractéristique du déséquilibre du pont résistif, signal
de déséquilibre, dont l'amplitude est pratiquement
proportionnelle à $1/R_s$. Ce signal, qui constitue une
mesure de la résistance de feuille du matériau, peut

6

être mesuré au moyen de divers détecteurs tels qu'un voltmètre numérique. L'amplificateur à verrouillage sensible à la phase répond à la modification de la phase du signal de déséquilibre par rapport à celle du signal de sortie de l'oscillateur, en fournissant un signal de commande à un oscillateur commandé en tension afin de décaler la fréquence de sortie de celui-ci et de ramener le pont à un mode résistif de fonctionnement.

L'appareil de la présente invention, qui permet de mesurer la résistance de feuille d'un matériau, comprend un circuit en pont fonctionnant en courant alternatif qui comporte un circuit accordé comprenant un élément inductif qui produit un champ magnétique lorsque le circuit en pont est excité. Ce dernier est déséquilibré résistivement et réactivement et fournit un signal dit de déséquilibre de pont lorsque des courants de Foucault sont engendrés dans le matériau dont on désire mesurer la résistance de feuille quand celui-ci est disposé à proximité immédiate de l'élément inductif. Un oscillateur commandé en tension comporte une borne de commande et une borne de sortie à laquelle est obtenu un signal en courant alternatif qui permet d'exciter le circuit en pont. L'appareil comprend également des moyens permettant, en réponse à la modification de la phase du signal de déséquilibre de pont par rapport à celle du signal de sortie de l'oscillateur, d'obtenir un signal de commande qui est appliqué à la borne de commande de l'oscillateur afin de modifier la fréquence de celui-ci et de contre-balancer la modification qui s'est produite dans la partie réactive du circuit en pont lorsque ce dernier s'est trouvé

7

déséquilibré, l'amplitude dudit signal de déséquilibre étant inversement proportionnelle à la résistance de feuille du matériau.

D'autres objets, caractéristiques et avantages de la présente invention ressortiront mieux de l'exposé qui suit, fait en référence aux dessins annexés à ce texte, qui représentent un mode de réalisation préféré de celle-ci.

Brève description des dessins

La figure 1 représente schématiquement un réseau permettant de mesurer la résistance de feuille d'un matériau.

La figure 2 représente schématiquement le circuit équivalent du circuit accordé de la figure 1, lorsqu'un échantillon de matériau dont on désire mesurer la résistance de feuille est introduit dans l'entrefer de la bobine toroïdale.

La figure 3 est un graphique représentant l'amplitude de l'angle de phase et de la réactance d'un circuit accordé présentant un facteur Q élevé, en fonction de la fréquence.

La figure 4 est un graphique représentant l'amplitude d'un signal de déséquilibre du pont en fonction de la résistance de feuille de différents matériaux faisant l'objet des mesures.

La figure 5 représente schématiquement l'un des amplificateurs à verrouillage du réseau de la figure 1.

8

La figure 6 est un diagramme de phase destiné à faciliter la compréhension du fonctionnement du réseau de la figure 5.

La figure 7 représente schématiquement un détecteur sélectif de fréquence qui peut être utilisé aux fins de la mise en oeuvre de la présente invention.

Mode de réalisation de l'invention

Le procédé de mesure sans contact de la résistance de feuille d'un matériau consiste, conformément à la présente invention, à mesurer les effets sur un circuit accordé excité des pertes dues aux courants de Foucault, qui se produisent à des fréquences ultrasoniques dans un matériau faisant l'objet de mesure. Le circuit accordé constitue l'une des branches d'un circuit en pont fonctionnant en courant alternatif et comporte une inductance d'accord composée d'un noyau toroïdal constitué par une ferrite autour de laquelle est enroulée une bobine et qui comporte un entrefer. Le champ magnétique alternatif créé dans cet entrefer induit dans ledit matériau des courants de Foucault qui exigent une détection précise. La perturbation de ce champ, qui résulte de l'introduction dudit matériau, a pour effet de déséquilibrer le pont résistivement et réactivement. L'emploi du circuit de mesure de la présente invention permet de ne mesurer que la modification résistive qui se produit dans le circuit, afin de déterminer la résistance de feuille du matériau, puisque la modification réactive est contre-balancée. En effet, un dispositif d'accord automatique de fréquence maintient le circuit en pont dans un mode de fonctionnement essentiellement résistif lorsque la valeur de l'inductance est modifiée par l'échantillon du matériau.

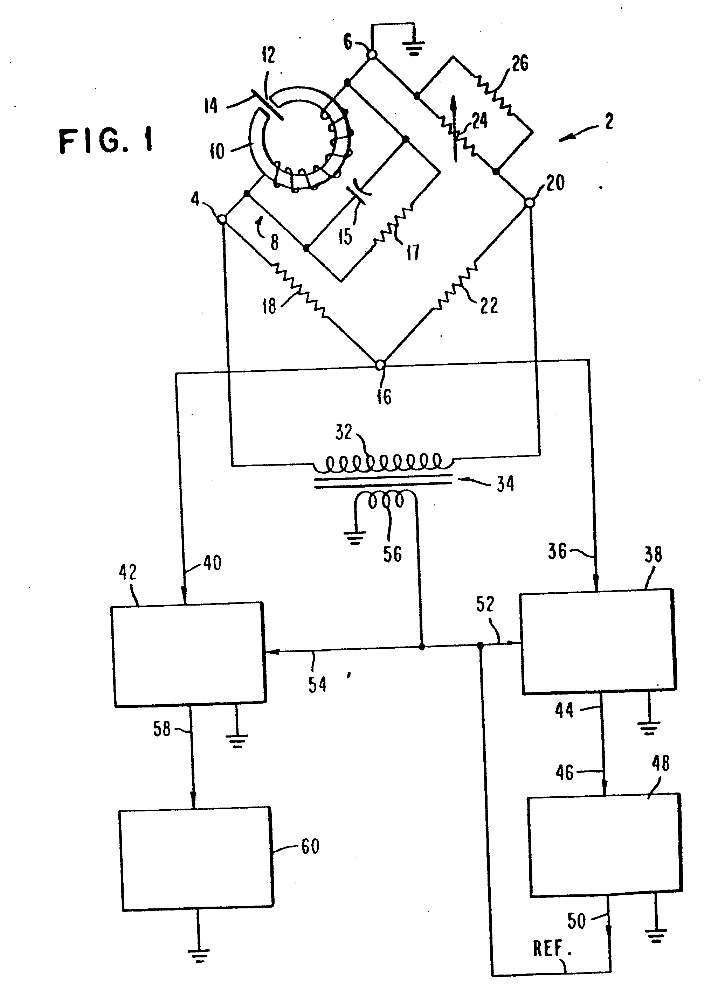

On se reportera à présent à la figure 1 qui représente un circuit résistif en pont 2 fonctionnant en courant alternatif. Un circuit accordé 8, qui comporte un noyau 10 de ferrite autour de laquelle est entourée une bobine et qui comprend un entrefer 12 dans lequel un échantillon d'un matériau 14 peut être introduit, est situé dans l'une des branches du pont entre les noeuds 4 et 6. Un condensateur 15 et une résistance 17 sont montés en parallèle avec le noyau 10 de manière à former le circuit accordé 8. Une résistance 18 de valeur fixe, c'est-à-dire une résistance bobinée, ou similaire, est montée entre les noeuds 4 et 16 dans une seconde branche du pont. Une résistance de valeur fixe 22, dont la valeur est la même que celle de la résistance 18, est montée dans la troisième branche du pont entre les noeuds 16 et 20. Une résistance de valeur variable 24, qui permet d'équilibrer le pont lorsque celui-ci n'est pas perturbé par la présence de l'échantillon 14, est montée entre les noeuds 6 et 20 dans la quatrième branche du pont. Une résistance 26, de même valeur que la résistance 17, est montée en parallèle avec la résistance 24 et fait fonction de charge résistive de shunt pour diminuer la sensibilité du circuit en pont, ce qui est nécessaire lorsqu'on mesure de faibles valeurs de $R_s$. Le secondaire 32 d'un transformateur de pont 34 constitue la première diagonale du pont entre les noeuds 4 et 20. Connectées dans la deuxième diagonale du pont entre les noeuds 6 et 16 se trouvent les entrées respectives 36 et 40 de deux amplificateurs à verrouillage 38 et 42 qui sont respectivement sensibles à la phase et à l'amplitude.

10

La sortie 44 de l'amplificateur 38 est connectée à une entrée 46 d'un oscillateur commandé en tension 48 dont la sortie 50 est reliée à une entrée de référence 52 de l'amplificateur 38, à une entrée de référence 54 de l'amplificateur 42 et au primaire 56 du transformateur de pont 34. La sortie 58 de l'amplificateur 42 est reliée à un dispositif d'enregistrement 60.

Le dispositif 2 fonctionne de la façon suivante: on retire de l'entrefer 12 l'échantillon 14 dont la résistance de feuille est inconnue, et on suppose que les valeurs des résistances 17 et 26 sont infinies. Alors, à la fréquence de résonance $f_o$, ici définie comme étant la fréquence à laquelle l'impédance du circuit accordé 8 est purement résistive, (c'est-à-dire que le circuit équivalent du circuit 8 est une résistance de valeur $R_p$), on règle la valeur de la résistance 24 de manière à équilibrer le pont, c'est-à-dire qu'un signal minimum est détecté par l'amplificateur à verrouillage 42. Lorsque l'échantillon 14 est introduit dans l'entrefer 12, la distribution du champ magnétique alternatif dans cet entrefer est perturbée et rend le circuit équivalent identique à celui représenté sur la figure 2. Dans ce dernier circuit, $\Delta X$ est la composante réactive due à la perturbation de la distribution du champ dans l'entrefer, et le terme $\Delta R$, qui est approximativement égal à $G_s$, est la composante résistive due aux pertes provoquées par les courants de Foucault induits dans l'échantillon 12 de conductance de feuille $G_s$, où $G_s$ est égal à $\sigma t$; $\sigma$ est la conductivité dans la masse de l'échantillon; t est l'épaisseur de l'échantillon 14; et $G_s = 1/R_s$.

11

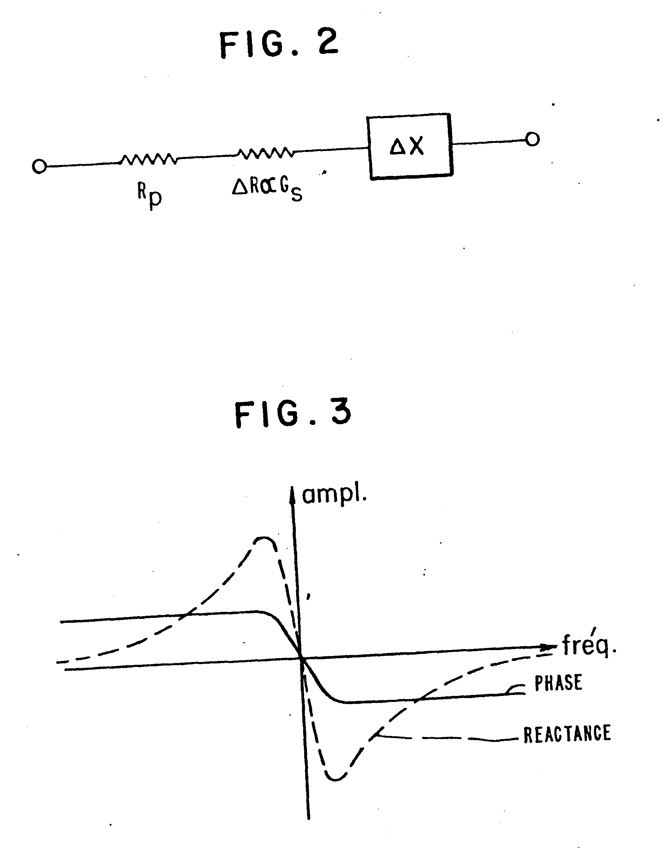

Lorsque l'échantillon 14 se trouve dans l'entrefer 12, comme le montre la figure 1, le pont résistif ne peut pas être équilibré à la fréquence $f_o$ en raison de la présence de $\Delta X$. Néanmoins, en décalant légèrement la fréquence de commande de telle sorte qu'elle soit égale à une fréquence $F_1$, où $\Delta X$ tend vers 0, le pont devient équilibré, cependant que $R_p$ et $\Delta R$ restent pratiquement inchangés, et $\Delta R$, la résistance de feuille, peut être déterminée. La réalisation de l'accord fin nécessaire est automatiquement obtenu avec précision grâce à l'amplificateur à verrouillage 38, qui est sensible à la phase. On tire ici parti du fait que la réactance et l'angle de phase d'un circuit accordé présentant un facteur Q élevé changent très rapidement lorsque la fréquence est proche de la fréquence de résonance, comme le montre la figure 3. A une fréquence voisine de $f_o$, le déphasage du signal de déséquilibre présent au noeud 16, qui est contrôlé par l'amplificateur 38 sensible à la phase, produit à la borne de sortie 44 un signal continu de commande qui est proportionnel au déphasage du signal de déséquilibre de pont obtenu au noeud 16. Le signal de sortie de l'amplificateur 38 est utilisé pour décaler dans le sens approprié, la fréquence de l'oscillateur commandé en tension 48, lequel fournit à sa sortie 50 un signal de référence qui est respecti- vement appliqué aux bornes 52 et 54 des amplificateurs 38 et 42, et qui fournit également un signal de commande au primaire 56 du transformateur de pont 34 de manière à produire un signal de contre-réaction dont la fréquence est commandée pour contraindre le circuit en pont à rester en permanence équilibré résistivement, en raison du fait que la modification de la composante réactive, $\Delta X$ est contre-balancée. Le signal de déséquilibre de pont obtenu au noeud 16 est proportionnel à

12

$G_s$ et est mesuré par l'amplificateur à verrouillage 42 qui est sensible à l'amplitude. L'emploi d'un tel amplificateur permet d'obtenir une mesure présentant un maximum de sensibilité dans le cas de valeurs élevées de $R_s$, mais dans le cas de valeurs plus faibles, des détecteurs plus simples peuvent être utilisés. Le courant continu qui est obtenu à la sortie de l'amplificateur 42 et qui est proportionnel à $1/R_s$, est transmis au dispositif d'enregistrement 60 et fournit une indication de la résistance de feuille de l'échantillon 14.

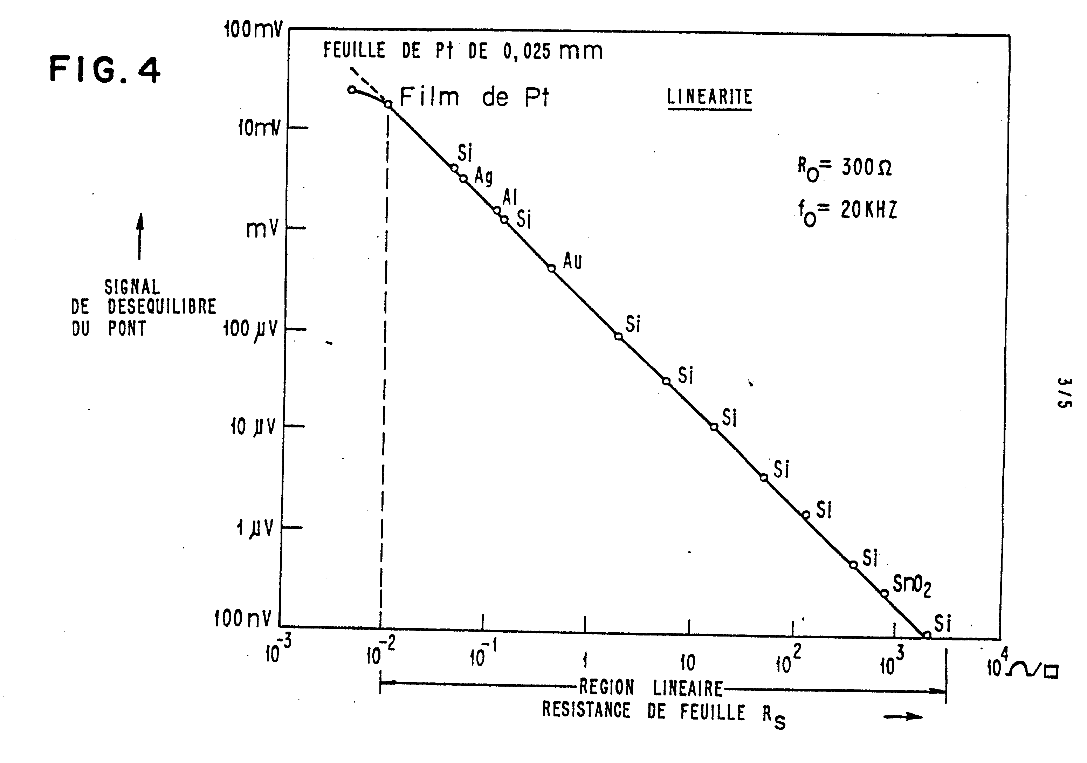

La figure 4 est un graphique représentant le signal de déséquilibre du pont en fonction de la résistance de feuille, $R_s$, pour divers matériaux, lorsque toutes les valeurs de $R_s$ sont mesurées au moyen de la technique classique qui fait appel à l'emploi d'une sonde à quatre points de contact. Ces données ont été établies pour une valeur de 300 ohms des résistances 17 et 26. Le graphique permet de mesurer des valeurs de $R_s$ comprises dans une gamme allant de $10^{-2}$ à $3 \times 10^3$ $\Omega/\square$. Pour de plus faibles valeurs de $R_s$, le système de réaction est surchargé; cela peut être évité soit en diminuant la valeur des résistances 17 et 26, soit en simplifiant le système en supprimant l'amplificateur à verrouillage 42 et en observant la tension continue de sortie de l'amplificateur à verrouillage 38, laquelle est proportionnelle à $G_s$. L'un des avantages que présente l'emploi de tels amplificateurs et du circuit de pont automatiquement accordé, est que des valeurs beaucoup plus faibles de $R_s$ peuvent être mesurées avant que l'effet de peau ne devienne un problème parce que des fréquences relativement basses peuvent être employées. A 20 kHz, on obtient une amélioration d'un facteur

13

de $\sqrt{10MHz/20KHz} \simeq 25$ de la sensibilité des mesures par comparaison avec la sensibilité obtenue à 10 MHz selon le procédé décrit dans le brevet précité des E.U.A. No. 4 000 458. Le procédé de la présente invention permet de mesurer des valeurs de $R_s$ comprises dans une gamme approximative de $5 \times 10^{-5}$ à $10^5$ ohm/□.

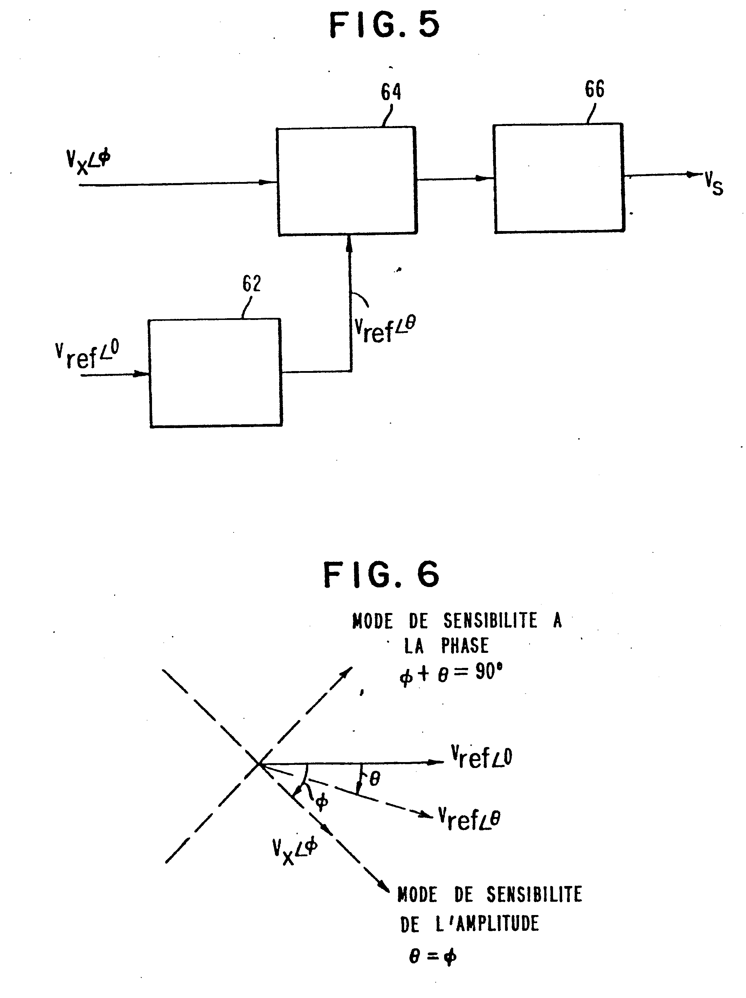

On a schématiquement représenté sur la figure 5 un amplificateur à verrouillage qui peut être employé comme amplificateurs 38 et 42 (voir figure 1). Cet amplificateur se compose principalement d'un dispositif de commande de phase 62, d'un mélangeur sensible de phases 64 et d'un filtre passe-bas 66. Un signal sinusoïdal de faible amplitude, qui est en l'occurrence le signal de déséquilibre obtenu au noeud 16, comme le montre la figure 1, et que l'on désignera ici au moyen de la notation $V_X \underline{/\phi}$ est appliqué au mélangeur sensible de phase 64 ainsi qu'un signal sinusoïdal de référence, $V_{ref}\underline{/\theta}$, qui est le signal de sortie du dispositif 62, obtenu après que la phase du signal d'entrée de ce dispositif, $V_{ref} \underline{/0}$, ait été modifiée manuellement, au moyen de ce dernier, d'un angle $\theta$. Le signal obtenu à la sortie du mélangeur 64 est un signal continu proportionnel à $V_{ref} V_X \cos(\phi-\theta)$, lequel signal est lissé par le filtre passe-bas 66.

Le diagramme de phase de la figure 6 illustre les différents modes de fonctionnement de l'amplificateur à verrouillage. Un choix approprié de la valeur de l'angle $\theta$ commandée par le dispositif 62 permet de faire fonctionner l'amplificateur dans deux modes distincts de fonctionnement ou dans une combinaison de ces derniers. Si l'on choisit le mode dit de sensibilité à l'amplitude,

14

qui est le mode de fonctionnement de l'amplificateur
42, le signal $V_{ref} \underline{/\theta}$ est en phase avec le signal
$V_X \underline{/\phi}$ , c'est-à-dire que $\theta=\phi$, de telle sorte que les
variations de l'amplitude de $V_X$, c'est-à-dire les
variations de l'amplitude du signal de déséquilibre
obtenu au noeud 16, produisent des variations correspondantes proportionnelles de l'amplitude du signal
de sortie $V_S$ du filtre passe-bas 66. Dans le mode dit
de sensibilité à la phase, ce qui est le mode de fonctionnement de l'amplificateur 38, lorsque $V_{ref} \underline{/\theta}$
est déphasé de 90° par rapport à $V_X \underline{/\phi}$ , c'est-à-dire
que $\phi+\theta=90°$, les variations de la phase de $V_X$ produisent
des variations correspondantes proportionnelles de
l'amplitude du signal de sortie $V_S$ du filtre 66. Ainsi,
le signal de sortie de l'amplificateur 38 qui est
transmis à l'oscillateur 48 commande la fréquence de ce
dernier en fonction de la différence de phase détectée
entre le signal de déséquilibre et le signal de sortie
de l'oscillateur.

L'amplificateur à verrouillage 42 peut être remplacé
par d'autres dispositifs moins coûteux si l'on doit
mesurer des résistances de feuille de métal de faibles
valeurs de $R_S$. A titre d'exemple, l'amplificateur 42
peut être supprimé et le signal continu de commande qui
est obtenu à la borne de sortie 44 de l'amplificateur
38 peut être mesuré au moyen d'un voltmètre numérique
pour déterminer la valeur de $R_S$, puisque ce signal
continu est proportionnel à $1/R_S$. Ce procédé de mesure
peut être employé, puisqu'il est linéaire, dans le cas
de résistances comprises dans une gamme de 0,003 à
3 $\Omega/\square$ environ.

Selon une autre solution, l'amplificateur à verrouillage

15

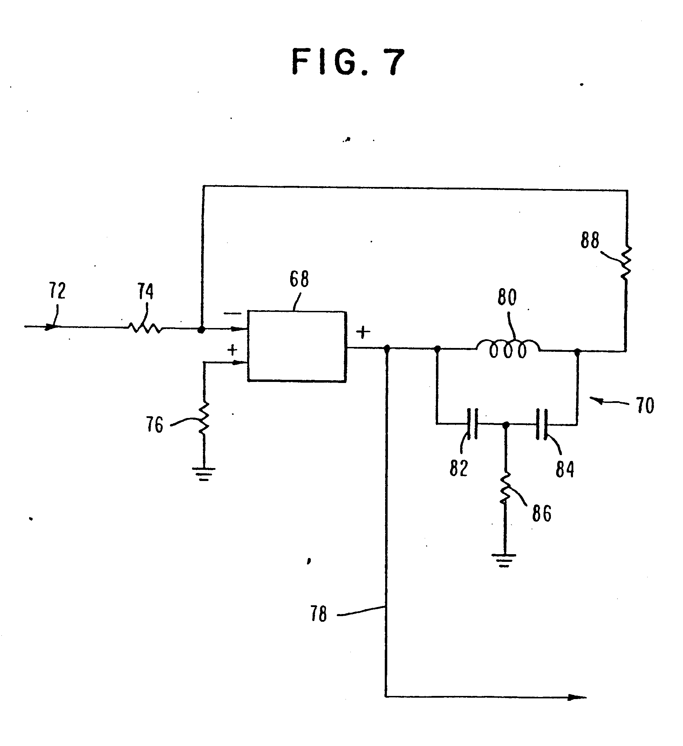

42 peut être remplacé par un détecteur sélectif de fréquence relativement peu coûteux du type représenté sur la figure 7. Ce détecteur comprend un amplificateur opérationnel 68 et un réseau ponté en T 70. L'entrée 72 du circuit est connectée au noeud 16, le signal de déséquilibre du pont étant appliqué par l'intermédiaire d'une résistance 74 à l'entrée négative de l'amplificateur 68. L'entrée positive de ce dernier est reliée à la masse par l'intermédiaire d'une résistance 76. Le signal alternatif de sortie de l'amplificateur 68 est appliqué par l'intermédiaire d'une ligne 78 à un redresseur approprié et à un indicateur en courant continu (non représenté) afin d'obtenir une indication de la résistance de feuille mesurée. Le signal de sortie de l'amplificateur 68 est également appliqué au réseau ponté en T 70, qui comprend une self 80, des condensateurs 82 et 84, et une résistance 86, reliée à la masse. Le signal filtré émanant du réseau 70 est appliqué comme signal de réaction, par l'intermédiaire d'une résistance 88, à l'entrée négative de l'amplificateur 68. Le détecteur représenté sur la figure peut être employé pour mesurer des résistances de feuille comprises dans une gamme dont la limite supérieure est d'environ 500 ohms/□.

Lorsque l'échantillon présente une $R_s$ supérieure à $10^3$ $\Omega$/□ environ, la dérive en courant continu des amplificateurs à verrouillage 38 et 42 peut augmenter. Cette dérive est due à de légères modifications thermiques qui se produisent dans le noyau en ferrite 10 et qui affectent l'entrefer. En utilisant des techniques standard de perturbation cyclique, la gamme des valeurs de $R_s$ mesurées peut devenir plus étendue et être

0007408

16

comprise entre $2 \times 10^3$ et $2 \times 10^5$ $\Omega/\Box$ environ. L'échantillon dont on désire mesurer la $R_s$ est monté sur un disque rotatif isolant (non représenté) de manière à faire passer l'échantillon dans l'entrefer 12 cinq fois par seconde environ. Le signal de sortie de l'amplificateur 42 est alors appliqué à un dispositif qui détermine la valeur moyenne des signaux. Cela permet de diminuer considérablement les effets de la dérive.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

17

REVENDICATIONS

1. Appareil pour mesurer la résistance de feuille d'un matériau, caractérisé en ce qu'il comprend:

un réseau en pont qui comporte un circuit accordé comprenant un élément inductif produisant un champ magnétique lorsque ce réseau est excité, ce dernier devenant déséquilibré résistivement et réactivement et produisant un signal dit de déséquilibre en réponse aux courants de Foucault qui sont produits dans ce matériau lorsque celui-ci est placé à proximité immédiate de cet élément inductif;

un oscillateur comportant une borne de commande et une borne de sortie à laquelle un signal alternatif est obtenu qui permet d'exciter le réseau en pont; et

des moyens permettant, en réponse à une modification de la phase du signal de déséquilibre par rapport à celle du signal alternatif obtenu à la sortie de l'oscillateur, lorsque ce matériau est disposé à proximité immédiate dudit élément inductif, de fournir un signal de commande appliqué à la borne de sortie de l'oscillateur afin de modifier la fréquence de sortie de celui-ci de manière à contre-balancer la modification qui se produit dans la partie réactive du réseau en pont et qui résulte du déséquilibre de ce dernier, l'amplitude du signal de déséquilibre étant inversement proportionnelle à la résistance de feuille du matériau.

18

2. Appareil selon la revendication 1, caractérisé en ce que ledit élément inductif est une bobine toroïdale ou un noyau de ferrite comportant un entrefer dans lequel le matériau est disposé de manière à déséquilibrer le réseau.

3. Appareil selon la revendication 1 ou 2, caractérisé en ce que les moyens qui répondent à une modification de la phase du signal de déséquilibre comprennent un amplificateur à verrouillage sensible à la phase de manière à obtenir un signal continu de sortie qui est proportionnel à la modification de phase détectée du signal de déséquilibre.

4. Appareil selon la revendication 3, caractérisé en ce que cet oscillateur est un oscillateur commandé en tension qui reçoit ce signal continu de sortie à sa borne d'entrée de manière à commander sa fréquence de sortie.

5. Appareil selon l'une des revendications 1 à 4, caractérisé en ce qu'il comprend un amplificateur à verrouillage sensible à l'amplitude qui, en réponse au signal de déséquilibre, fournit un signal de sortie inversement proportionnel à la résistance de feuille du matériau.

6. Appareil selon l'une des revendications 1 à 4, caractérisé en ce qu'il comprend un détecteur sélectif de fréquence qui, en réponse au signal de déséquilibre du réseau en pont, fournit un signal

19

de sortie inversement proportionnel à la résistance de feuille du matériau.

7. Appareil pour mesurer la résistance de feuille, $R_s$, d'un matériau, caractérisé en ce qu'il comprend:

un réseau en pont comportant trois branches qui sont résistives et une branche étant un circuit accordé comprenant une bobine toroïdale comportant un entrefer dans lequel le matériau est introduit pour mesurer la résistance de feuille, $R_s$, de celui-ci, ce réseau en pont étant excité aux bornes de sa première diagonale, un signal de déséquilibre du réseau en pont étant mesuré à l'un des noeuds de sa seconde diagonale, ce signal de déséquilibre étant obtenu en réponse aux courants de Foucault qui sont engendrés dans ce matériau lorsque celui-ci est introduit dans l'entrefer;

un transformateur dont le secondaire est connecté dans la première diagonale et qui comporte un enroulement primaire;

un oscillateur commandé en tension comportant une borne de commande et une borne de sortie connectée au primaire du transformateur, et un amplificateur à verrouillage sensible à la phase qui comporte une borne d'entrée connectée à ce noeud de cette seconde diagonale, une borne de sortie connectée à la borne de commande de cet oscillateur commandé en tension, et une borne de référence connectée à la borne de sortie de l'oscillateur commandé en

20

tension.

8. Appareil selon la revendication 7, caractérisé en ce que la résistance que comporte l'une des trois branches est une résistance variable.

9. Appareil selon la revendication 7 ou 8, caractérisé en ce que le circuit accordé comprend un condensateur et une résistance montée en parallèle avec la bobine toroîdale.

10. Appareil selon l'une des revendications 7 à 9, caractérisé en ce qu'il comprend un amplificateur à verrouillage sensible à l'amplitude qui comporte une borne d'entrée connectée au noeud de la seconde diagonale, une borne de référence connectée à la borne de sortie de l'oscillateur commandé en tension, et une borne de sortie à laquelle un signal est obtenu, lequel est proportionnel à $1/R_s$.

FIG. 1

# FIG. 2

$$R_p \qquad \Delta R \alpha G_S \qquad \Delta X$$

# FIG. 3

ampl.

fréq.

PHASE

REACTANCE

FIG. 4

# FIG. 5

$V_X \angle \phi$ → [64] → [66] → $V_S$

$V_{ref} \angle 0$ → [62]

$V_{ref} \angle \theta$

# FIG. 6

MODE DE SENSIBILITE A
LA PHASE
$\phi + \theta = 90°$

$V_{ref} \angle 0$

$\theta$

$\phi$

$V_{ref} \angle \theta$

$V_X \angle \phi$

MODE DE SENSIBILITE
DE L'AMPLITUDE
$\theta = \phi$

# FIG. 7

**Office européen des brevets**

## RAPPORT DE RECHERCHE EUROPEENNE

Numéro de la demande

EP 79 10 1841

| Catégorie | Citation du document avec indication, en cas de besoin, des parties pertinentes | Revendication concernée |
|---|---|---|
| | WESTERN ELECTRIC, Technical Digest, no. 33, janvier 1974, pages 43 à 44. J.H. MOSHER "A circuit for determining the resonance frequency and effective series resistance of an inductor-capacitor network ". <br><br> * Pages 43 et 44; figure * <br><br> -- <br><br> DE - B - 1 591 988 (PHILIPS' PATENTVERWALTUNGS GmbH) <br><br> * Colonne 1, lignes 1 à 25, résumé; colonne 2, lignes 21 à 68 et colonne 3 à colonne 4; figure * <br><br> -- | 1 <br><br><br><br><br><br><br><br><br> 1 |
| A | MESURES-REGULATION-AUTOMATISME, vol. 42, no. 1/21, janvier/février 1977, pages 19-23. "Du monde entier", "Une mesure de résistivité sans contact matériel". <br><br> * Page 19, colonne au milieu et à la droite; figure 1 * <br><br> -- | 1 |
| A | FR - A - 2 321 702 (WESTERN ELECTRIC COMPANY) <br><br> * Page 2, lignes 12 à 36; page 3, lignes 1 `6 et 26 à 33; figure 1 * <br><br> ---- | 1 |

**CLASSEMENT DE LA DEMANDE (Int. Cl. 3)**

G 01 R 27/02
        17/10
G 01 N 27/02

**DOMAINES TECHNIQUES RECHERCHES (Int. Cl. 3)**

G 01 R 27/00
       27/02
       17/10
       17/02
       17/06
G 01 N 27/02

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons

&: membre de la même famille, document correspondant

Le présent rapport de recherche a été établi pour toutes les revendications

| Lieu de la recherche | Date d'achèvement de la recherche | Examinateur |
|---|---|---|
| La Haye | 19-10-1979 | KUSCHBERT |

OEB Form 1503.1 06.78